# EUROPÄISCHE PATENTANMELDUNG

(11) **EP 0 847 090 A2**
(43) Veröffentlichungstag der Anmeldung: **10.06.1998**
(21) Anmeldenummer: 97118304.1
(22) Anmeldetag: 22.10.1997
(51) Int. Cl.: H01L 29/739

(54) **IGBT mit Trench- Gate- Struktur**

(30) Priorität: 06.12.1996 DE 19650599; 12.02.1997 DE 19705276
(71) Anmelder: SEMIKRON Elektronik GmbH, 90431 Nürnberg (DE)
(72) Erfinder: Herzer, Reinhard, Dr. habil., 98693 Ilmenau (DE); Netzel, Mario, 06242 Braunsbedra (DE)

(57) **Zusammenfassung**

Es wird ein Leistungshalbleiterbauelement beschrieben, das als TIBGT (Trench- Insulated-Gate- Bipolar- Transistor) ausgebildet ist. Der TIGBT, mit einem Substratgebiet des ersten Leitungstyps (1), mit einer vertikalen MOS- Struktur, mit streifen-, insel- oder gitterförmig angeordnete Trenchstrukturen (5), die allseitig zum Silizium hin mit einem Gateisolator (6) versehen, mit Polysilizium (7) verfüllt und mit einer Passivierungsschicht (8) abgedeckt sind, wird dadurch weiterentwickelt, in dem die Trenchstrukturen im Wechsel auf der einen vertikalen Flanke von vertikalen MOS- Strukturen, bestehend aus Bulkgebieten (2) des zweiten Leitungstyps, dessen Anschlußgebiete (4) vom zweiten Leitungstyp und den Source- bzw. Emitter- Gebieten (3) vom ersten Leitungstyp, und auf der anderen vertikalen Flanke von Isolatorgebieten (17), Dotierungsgebieten (18) des zweiten Leitungstyps oder von Substratgebieten des ersten Leitungstyps (1) umgeben sind.

## Beschreibung

Die Erfindung beschreibt einen IGBT (Insulated- Gate- Bipolar- Transistors) mit einer Graben-Gate- Struktur (auch Trench- Gate- Struktur genannt) nach den Merkmalen des Oberbegriffes des Anspruches 1.

Nach dem Stand der Technik sind IGBT mit Trench- Gate- Struktur in jüngster Zeit bekannt geworden. Trenchstrukturen an sich werden in großem Umfang für die Herstellung von Speicherzellen für hochintegrierte Speicherschaltkreise verwendet. Bekannt sind auch Leistungshalbleiterbauelemente mit Trenchstrukturen, insbesondere werden sie zur Realisierung des Gatekomplexes seit einiger Zeit eingesetzt. Hier seien beispielhaft vertikale DMOS- Transistoren (doppelt- diffundierte MOS- Transistoren) für den unteren Spannungsbereich (<100V) genannt.

Für diese Trench- MOS- Transistoren werden schmale Trenchgräben mit geringen vertikalen Tiefen verwendet, z.B. ca. 1,5µm Tiefe und ca. 1,5µm Breite für 50V- MOSFET. Dabei wird eine hohe Dichte dieser Trenchstrukturen angestrebt, um eine hohe Kanalweite pro Flächeneinheit zur erreichen. Die Herstellung des Trench- Gate- Komplexes für diese Trench-MOS- Transistoren entspricht dem Stand der Technik nach EP 0698 919 A2.

Der fachliche Hintergrund der Trenchtechnologie soll zunächst an einem Beispiel einer Anwendung näher erläutert werden, da Trench- Gate- Strukturen auch bereits für IGBT vorgeschlagen und verwendet wurden (IEDM, Techn. Digest., S. 674-677, 1987).

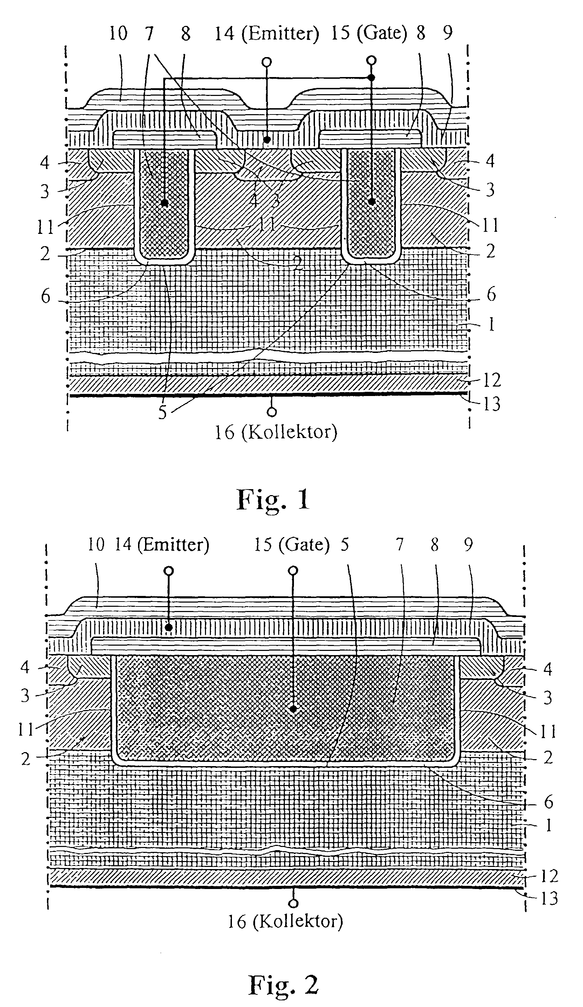

**Fig. 1** zeigt eine derartige Anordnung nach dem Stand der Technik in nicht maßstabsgerechtem Querschnitt einer Zelle als Skizze. Zunächst unterscheidet man prinzipiell erstens zwischen einem Nonpunchthrough- IGBT- Aufbau, gekennzeichnet durch ein dickes n⁻- Substrat (1) und einem dünnen, rückseitig implantierten p- Emitter (12) als Kollektor des Gesamtbauelementes, wie das in Fig. 1 dargestellt ist. Eine zweite nicht dargestellte Variante wird gebildet durch einen Punchthrough- IGBT- Aufbau, die durch ein p⁺- Substrat gekennzeichnet ist, auf dem eine erste n- dotierte Zwischenschicht und eine zweite niedrig dotierte epitaktisch abgeschiedene n⁻- Schicht aufgebracht wurden.

Die Zellstruktur an der Waferoberseite ist für beide Typen gleich. Sie besteht aus einem p- Bulkgebiet (2), den n⁺- Sourcegebieten (3) und den p⁺- Bulk- Anschlußgebieten (4), welche durch streifen- oder gitterförmig angeordnete vertikale Ätzgräben oder Trenches (5) unterbrochen werden. Diese Trenchstrukturen (5) sind allseitig zum Silizium hin mit einem Gateisolator (6) versehen, mit Polysilizium (7) verfüllt und nach oben zum Aluminium (9) hin mit einer Passivierungsschicht (8) abgedeckt.

Polysilizium (7), Gateisolator (6) und p- Gebiet (2) bilden einen MOS- Kondensator des internen MOSFET, dessen Kanal (11) zwischen dem n⁺- Sourcegebiet (3) und dem n⁻- Substrat (1) vertikal an der Seitenwand des Trenches entsteht. Die streifen- oder gitterförmig angeordneten Trench- Gate- Strukturen sind untereinander in z- Richtung zu einem gemeinsamen Gateanschluß (15) verbunden.

Die n⁺- Sourcegebiete (3) sowie die p⁺- Anschlußgebiete (4) aller so gebildeten Zellen werden über eine Aluminiummetallisierung (9) miteinander verbunden. Die Metallisierung stellt den Emitteranschluß (14) des IGBT dar. Die gesamte Struktur ist mit Ausnahme der Bondflächen mit einer Passivierungsschicht (10) abgedeckt. Der Kollektor (16) des IGBT wird durch eine weitere Metallisierung (13) an der Waferrückseite gebildet.

Der Stand der Technik beinhaltet auf dem relevanten Sektor der Leistungselektronik die Problematik der Anwendung von Trenches für abschaltbare Thyristoren in MOS- Technologie.

In US 5,329,142 wird sehr ausführlich und gewissenhaft die Halbleiterproblematik der IEGT-Technik für MOS- gesteuerte Thyristoren beschrieben. Multiple Trenchstrukturen, wie sie für die Verstärkung in der Thyristortechnik bei Hochspannungsbelastung zur Erzielung kleiner Flußspannungen Voraussetzung sind, werden mit ihren mehrfachen Trenchstrukturen dargestellt. Nur so ist in der Thyristortechnik eine massive Steigerung der Elektroneninjektionswirkung zu erzielen.

In dem dortigen Hauptanspruch, den Fig. 69, 71, 72, 74 und 75 und in den dazugehörenden Beschreibungstexten ist exakt und ausführlich die MOS- Thyristorstruktur dargestellt. Dazu ist eine ausführliche Darstellung erforderlich:

Das dortige zusätzliche p⁺- Gebiet (28) ist mit der Kathode (34) und das p⁻- Gebiet (18) ist nicht mit der Kathode (34) verbunden, damit ergibt sich eine (abschaltbare) MOS-Thyristorstruktur. Durch diese Konstruktion entstehen zwei schaltbare Zustände. Einerseits entsteht ein vertikaler n- Kanaltransistor, gebildet aus dem n⁻- Gebiet (12), dem p⁻- Gebiet (18), dem n⁻- Gebiet (26) und dem Trench- Gate, über welches der n- Kanal MOSFET bei positiver Gatespannung eingeschaltet wird (turn on- Transistor des Thyristors).

Andererseits entsteht ein vertikaler p- Kanal- Transistor, gebildet aus dem p⁻- Gebiet (18), dem n⁻- Gebiet (26), dem p⁺- Gebiet (28) und dem Trench- Gate, über welches der p- Kanal MOSFET bei negativer Gatespannung eingeschaltet wird (turn off- Transistor des Thyristors).

Genau dieser Aufbau und die sich daraus ergebenen Funktionen werden in Spalte 23, Z. 54 ff, und im 1. Anspruch erläutert (p/n/p/n- Struktur zwischen den Trenches sowie die erste Kanalregion (p- Kanal) und die zweite Kanalregion (n- Kanal)). Weiterhin werden multiple Trench- Strukturen gezeigt (Fig. 43 bis 47) und erläutert, bei denen auf beiden Seiten des Trenches p- Gebiete angeordnet sind. Diese sind für die Thyristorstruktur vorteilhaft, für einen IGBT jedoch sehr nachteilig.

Durch diese großen Gateflächen erhöht sich die Millerkapazität beträchtlich, was zu erhöhten Schaltverlusten führt. In Schaltungen mit Thyristoransteuerungen stört diese Tatsache bisher wenig, da mit kleinen Betriebsfrequenzen gearbeitet wird, der Vorteil der minimalen Flußspannungen besitzt hier die Priorität.

Für die erfinderische Aufgabenlösung mit den hier erforderlichen IGBT- Strukturen waren Problemlösungen, wie sie nach dem Stand der Technik vorgestellt wurden, nicht verwendbar, denn es werden sowohl kleine Flußspannungen als auch eine vergleichsweise kleine Millerkapazität gefordert, weil damit ein besserer Kompromiß zwischen Flußspannung und Schaltverlusten im Interesse höherer Betriebsfrequenzen erzielt wird.

Die dem Inhalt nach bekannten Problemlösungen, wie sie weiterhin in
- US 5,448,083,
- Mitsuhiko Kitawa et.al.:"4500V IEGTs having Switching Characteristics Superior go GTO" in Proceedings of 1995 International Symposium on Power Semicondauctor Devices & Ics, Yokahama, 486 - 490 und in
- Mitsuhiko Kitagawa et.al.: 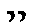 A 4500V Injection Enhanced Insulated Gate Bipolar Transistor..." in JEDM (1993), 679 - 682
offenbart worden sind, betreffen alle nicht eine für die eigene Aufgabenstellung naheliegende Struktur, sondern Aufbauten in Realisierung von IEGT- Strukturen. Andere Problemlösungen, wie in DE 43 24 481 A1 betreffen reine Randstruktur von IGBT:

Von Mitsubishi (Proc. ISPSD'94, S. 411-416, Davos, 1994) wurden, abgeleitet von den Trench- MOSFET- Strukturen, Trenchgates mit einer Tiefe von ca. 3µm und einer Breite von ca. 1µm für 600V- IGBT vorgestellt. Der Abstand der streifenförmigen Trenches wurde zwischen 3,5µm und 14µm variiert. Für kleine Abstände erhält man für diesen Trench- IGBT (TIGBT) ebenfalls eine hohe Dichte der Trenchstrukturen.

TIGBT dieser Art erreichen gegenüber IGBT mit planarem Gate eine deutlich reduzierte Flußspannung. Diese Verringerung wird insbesondere durch den geringen Kanalwiderstand aufgrund der hohen Kanalweite pro Flächeneinheit erreicht. Nachteilig ist jedoch, daß aufgrund der hohen Kanalweite das Sättigungsstromniveau gegenüber IGBT mit planarem Gate um ein Mehrfaches erhöht ist. Dadurch verkürzt sich die Zeitspanne erheblich, in der das Bauelement einen Kurzschluß ohne Zerstörung überstehen kann.

In jüngster Zeit wurden weitere Verbesserungen und Änderungen des Aufbau des Trench-Gate- Komplexes vorgeschlagen. So bewirkt eine Vertiefung der Trench- Gates, z.B. von 3µm auf 5µm oder 9µm eine weitere Verringerung der Flußspannung. Die Ecken dieser schmalen und tiefen Strukturen werden jedoch bei angelegter Sperrspannung erheblich belastet, was zu einer Verringerung des statischen Sperrvermögens und der Avalanchefestigkeit bei dynamischer Belastung führt.

Ein verbesserter Kompromiß für alle wichtigen Parameter wird jedoch erreicht, wenn der Trench- Gate- Komplex sehr breit ausgeführt wird. Breit ausgeführt bedeutet dabei, daß die Trenchbreite ein Mehrfaches der Trenchtiefe annimmt. Solche Strukturen wurden im Kolloquium 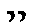 Halbleiterbauelemente und Materialgüte Silizium" Freiburg, 1995 und in ISPSD, von Yokohama 1995, S. 224- 229 vorgestellt.

In **Fig. 2** ist diese Designvariante dargestellt. Die breiten Trenchstrukturen (5) sind allseitig zum Silizium hin mit einem Gateisolator (6) versehen, vollständig mit Polysilizium (7) verfüllt und nach oben zum Aluminium (9) hin mit einer Passivierungsschicht (8) abgedeckt. Zwischen den streifen- oder gitterförmig angeordneten breiten Trench- Gate- Strukturen sind analog zur Fig. 1 die p- Bulkgebiete (2), die n⁺- Sourcegebiete (3) und die p⁺- Bulk- Anschlußgebiete (4) angeordnet.

Aufgrund der stark vergrößerten Trenchbreite ergeben sich große Zellen und damit eine erheblich verringerte Kanalweite pro Flächeneinheit gegenüber der Struktur in Fig. 1. Obwohl sich damit der Kanalwiderstand des internen MOSFET erhöht, wird bereits mit einer Trenchtiefe, die nur wenig größer als die Eindringtiefe des p- Bulkgebietes ist, eine geringere Flußspannung für das Gesamtbauelement, als mit schmalen und sehr tiefen Strukturen erreicht. Aufgrund der reduzierten Kanalweite verringert sich das Sättigungsstromniveau erheblich und liegt im Bereich der Werte für IGBT mit planarem Gate. Auch die Belastung der Trenchecken ist im Sperrfall im Vergleich zu schmalen und tiefen Trenches erheblich geringer.

Praktische Anwendungen für einen TIGBT mit breitem Trench- Gate- Komplex sind nicht bekannt. Insbesondere die Verfüllung und Planarisierung der Trenches ist mit herkömmlichen reinen Abscheideverfahren nicht so leicht realisierbar, es sind Kombinationen zwischen Abscheideverfahren und mechanisch- chemischen Planarisierungsverfahren notwendig.

Außerdem steigt mit der vergrößerten Gatefläche die sog. Millerkapazität an. Die Kenntnisse über die Wirkungsweise und Eigenschaften von IGBT mit einem solchen Trench- Gate-Komplex werden zum Stand der Technik gerechnet.

Die vorliegende Erfindung hat sich die Aufgabe gestellt, ein Leistungshalbleiterbauelement in der Form eines Trench- Gate- IGBT darzustellen, das neben hohen Sperrspannungen und geringen Durchlaßverlusten auch geringe Schaltverluste und kleine Sättigungsströme aufweist. Die erfinderische Aufgabenstellung wird ergänzt durch Ausnutzung der p- Gebiete von Trench- IGBT durch Integration von lateralen und/oder vertikalen Bauelementen bzw. Schaltungen.

Die Aufgabe wird bei Leistungshalbleiterbauelementen mit IGBT- Trench- Gate- Struktur der dargestellten Art durch die Maßnahmen des kennzeichnenden Teiles des Anspruches 1 gelöst, bevorzugte Weiterbildungen werden in den Unteransprüchen dargestellt.

Die Erfindung wird nachfolgend durch die Beschreibung des Trench- Gate- Komplexes dargestellt.

Die wesentliche erfinderische Idee besteht, in Verbindung mit weiteren noch zu beschreibenden Maßnahmen darin, die Wirkung des breiten Trench- Gates durch zwei schmale spezifische Trenchstrukturen nachzubilden, die technologisch einfacher zu realisieren sind.

Die erfinderischen Gedanken werden auf der Grundlage der Fig. 1 bis 19 erläutert:
- **Fig. 1**: zeigt eine bereits beschriebene Anordnung nach dem Stand der Technik.
- **Fig. 2**: ist eine Variante der Zellgestaltung nach dem Stand der Technik skizziert.
- **Fig. 3**: zeigt den Querschnitt einer Variante der erfinderischen Struktur in Skizze.
- **Fig. 4**: beschreibt eine weitere Variante in Weiterentwicklung analog zu Fig. 3.
- **Fig. 5**: stellt in analoger Skizze die komplexe Anwendung der erfinderischen Gedanken vor.
- **Fig. 6**: gibt ein Beispiel für eine mögliche äußere Beschaltung nach Fig. 5 an.
- **Fig. 7**: beschreibt die elektrisch Wirkung der Maßnahmen nach Fig. 5.
- **Fig. 8**: erläutert eine weitere Variante einer beispielhaften Schaltungsanordnung nach Fig. 5.
- **Fig. 9**: stellt die Gesamtverluste verschiedener Trench- Gate- Strukturen in Abhängigkeit von der Schaltfrequenz dar.
- **Fig. 10**: stellt in Skizze beispielhaft die Integration von Bauelementen im p- Gebiet dar.
- **Fig. 11**: zeigt eine mögliche Beschaltung der IGBT- Struktur nach Fig. 10.
- **Fig. 12**: skizziert eine andere mögliche Variante der Trench- Struktur mit integriertem Einschaltwiderstand (Rₚ).
- **Fig. 13**: zeigt eine Draufsicht einer IGBT- Struktur mit streifenförmigem Design nach Fig. 1.
- **Fig. 14**: stellt eine weitere Variante nach Fig. 13 dar.
- **Fig. 15**: zeigt eine Draufsicht der erfinderischen Trench- Gate- Struktur in Streifenform.
- **Fig. 16**: zeigt im Querschnitt die einfachste Möglichkeit einer Ausführung nach Fig. 5 mit floatendem p- Gebiet.
- **Fig. 17**: stellt die Inselstruktur der Trench- Gate- Zellen dar.
- **Fig. 18**: zeigt eine mögliche erfinderische Variante für die elektrische Verbindung der Struktur nach Fig. 17.
- **Fig. 19**: zeigt die Draufsicht der Trench- Gate- Struktur nach Fig. 12 bei zellförmigem Design.

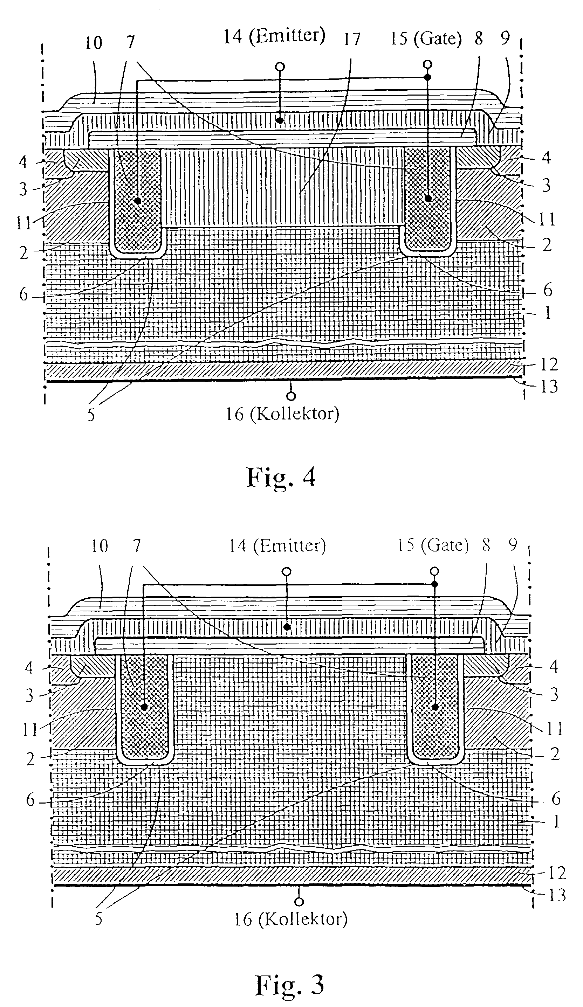

**Fig. 3** zeigt einen, zu den bereits beschriebenen Fig. 1 und 2 analogen, Ausschnitt einer IGBT-Zellstruktur, die die grundlegende Wiederholstruktur des Gesamtbauelementes darstellt und auf dessen Basis der erfinderische Gehalt beschrieben wird. Der Abstand der beiden schmalen Trenchstrukturen entspricht dabei der günstigsten Breite des Trench- Gate- Komplexes aus Fig. 2. Im Unterschied zum Stand der Technik wird der vertikale MOS- Kanal (11) nur an den jeweiligen Außenseiten der beiden schmalen Trenchstrukturen erzeugt.

Zwischen den beiden Trenchstrukturen (5) befindet sich zunächst Substratmaterial (1). Die Trenchstrukturen (5) sind allseitig zum Silizium hin mit einem Gateisolator (6) versehen, vollständig mit Polysilizium (7) verfüllt und nach oben zum Aluminium (9) hin mit einer Passivierungsschicht (8) abgedeckt. Zwischen den streifen- oder gitterförmig angeordneten Trench- Gate- Strukturen sind im Wechsel auf der einen Seite die p- Bulkgebiete (2), die n⁺-Sourcegebiete (3) und die p⁺- Bulk- Anschlußgebiete (4) und auf der jeweils anderen Seite das Substratgebiet (1) angeordnet.

Mit dieser Struktur werden gleiche Flußspannungen und Sättigungsströme wie mit der Struktur in Fig. 2 erreicht. Vorteilhaft im Vergleich zu der Struktur in Fig. 2 ist die einfachere technologische Realisierbarkeit, speziell das Ätzen und Verfüllen der schmalen Trenches. Allerdings ergibt sich eine inhomogene Ladungsträgerverteilung im n⁻- Gebiet (1) zwischen den Trenchzellen, die sich nachteilig auf die dynamischen Eigenschaften des Bauelementes auswirkt. Eine Verkleinerung der Millerkapazität und damit eine Verringerung der Schaltverluste sowie eine Verbesserung der Homogenität der Ladungsträgerverteilung wird durch die Realisierung der nachfolgend dargestellten weiteren erfinderischen Gedanken erreicht.

Eine erste Möglichkeit besteht darin, das n⁻- Substratgebiet (1) zwischen den Trenchstrukturen vertikal teilweise oder auch ganz zu entfernen und durch ein dickes Isolationsgebiet zu ersetzen. Die Dicke des Isolators wird dabei so gewählt, daß die obere Ausdehnung des Isolators entweder unterhalb der ehemaligen Substratoberfläche endet, in der Höhe derselben liegt oder darüber hinaus ragt.

**Fig. 4** beschreibt eine Weiterentwicklung analog zu Fig. 3 Es ist wiederum eine IGBT-Zellstruktur dargestellt. In diesem Ausführungsbeispiel liegt die obere Begrenzung des Isolators (17) in Höhe der ehemaligen Substratoberfläche und es erfolgte eine nahezu vollständige Entfernung des Substratgebietes (1) zwischen den Trenchstrukturen. Die Trenchstrukturen (5) sind allseitig zum Silizium hin mit einem Gateisolator (6) versehen, vollständig mit Polysilizium (7) verfüllt und nach oben zum Aluminium (9) hin mit einer Passivierungsschicht (8) abgedeckt.

Zwischen den streifen- oder gitterförmig angeordneten Trench- Gate- Strukturen sind im Wechsel auf der einen Seite die p- Bulkgebiete (2), die n⁺- Sourcegebiete (3) und die p⁺- Bulk-Anschlußgebiete (4) und auf der anderen Seite das Isolatorgebiet (17) angeordnet.

Je dicker das Isolatorgebiet (17) zwischen den Trenches gewählt wird, um so geringer wird die Millerkapazität, die Homogenität der Ladungsträgerverteilung verbessert sich. Die Belastung der Trenchecken auf der Seite des Isolatorgebietes (17) wächst im Sperrfall jedoch an.

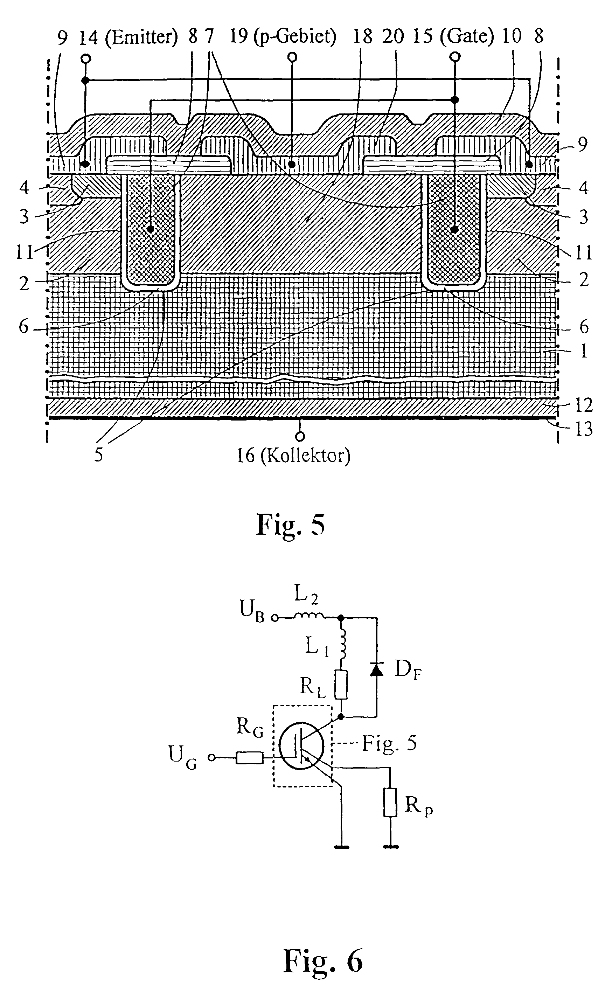

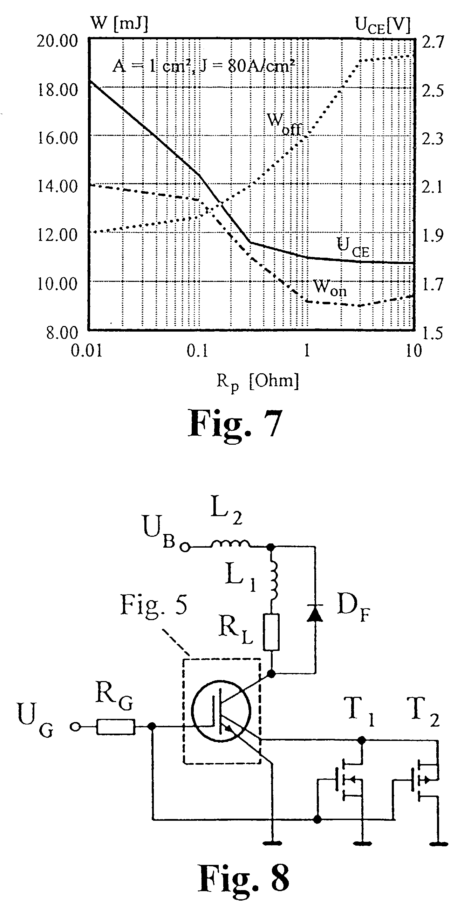

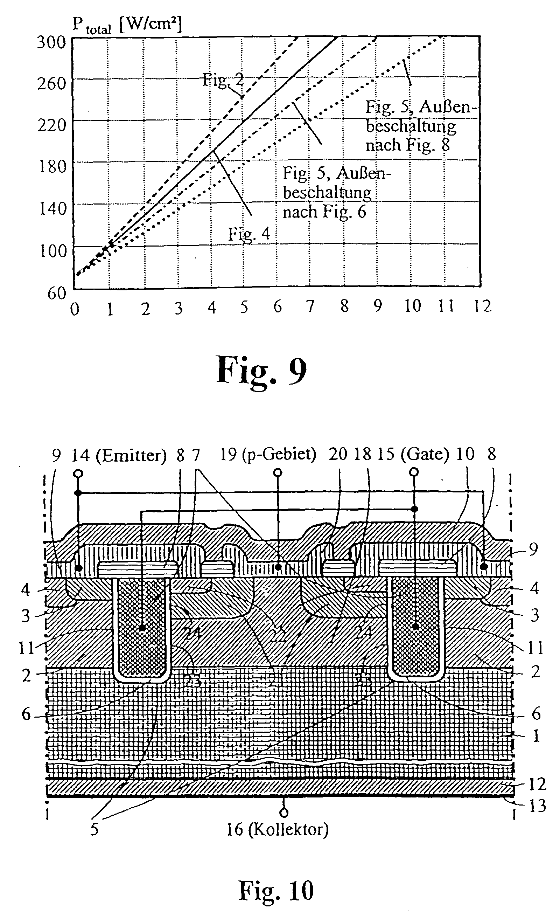

**Fig. 5** stellt die Anwendung der erfinderischen Gedanken in einem zu den vorhergehenden Figuren analogen Ausschnitt einer IGBT- Zellstruktur vor. Die Idee besteht darin, anstelle des Isolatorgebietes (17 in Fig. 4) ein p- Gebiet (18) einzufügen. Das p- Gebiet (18) besitzt eine geringere oder gleiche Eindringtiefe in Relation zu dem p- Bulkgebiet (2).

Die Eindringtiefe kann alternativ so gewählt werden, daß die inneren Trenchecken der Struktur umschlossen werden. Die Trenchstrukturen (5) sind wiederum allseitig zum Silizium hin mit einem Gateisolator (6) versehen, vollständig mit Polysilizium (7) verfüllt und nach oben zum Aluminium (9) hin mit einer Passivierungsschicht (8) abgedeckt.

Zwischen den in gleicher Weise streifen- oder gitterförmig angeordneten Trench- Gate-Strukturen sind im Wechsel auf der einen Seite die p- Bulkgebiete (2), die n⁺- Sourcegebiete (3) und die p⁺- Bulk- Anschlußgebiete (4) und auf der anderen Seite das p- Gebiet (18) angeordnet.

Im elektrischen Sinne kann das p- Gebiet einerseits floatend betrieben werden, der Anschluß (19) ist in diesem Falle nicht notwendig. Andererseits kann über den Anschluß (19) und die Metallisierung (20) an das p- Gebiet ein äußeres Potential direkt oder über weitere Elemente angeschlossen werden. Weitere Elemente können beispielhaft ein fester Widerstand, ein gesteuerter Widerstand oder eine externe oder integrierte elektronische Schaltung sein.

In einer Anordnung wechseln sich vertikale MOS- Strukturen einerseits und andererseits p-Gebiete (18) oder Substratgebiete (1) oder Isolationsgebiete (17) in strenger Regelmäßigkeit ab, diese Zellwiederholstruktur ist verbindlich.

Mit der Struktur entsprechend Fig. 5 werden ebenso geringe Flußspannungen erreicht, wie mit den bisher vorgestellten der Figuren 2 bis 4. Hier ist jedoch die Millerkapazität reduziert und es sind damit die Schaltverluste verringert. Weiterhin erfolgt durch das eingefügte p- Gebiet ein Schutz gegen unerwünschte Avalanchegeneration bei Sperrbelastung an den Trenchecken auf der Seite des p- Gebietes (18). Die beste Wirksamkeit ist hier bei Umschließung dieser Ecken durch das zusätzliche p- Gebiet gegeben. Alle nicht mehr beschriebenen Skizzenbereiche sind mit gleicher Numerierung bereits in früheren Figuren dargestellt.

**Fig. 6** zeigt ein Beispiel für eine mögliche äußere Beschaltung der Struktur nach Fig. 5. Die prinzipielle Schaltung, wie das p- Gebiet direkt oder über weitere Bauelemente an ein äußeres Potential, wie beispielsweise über den Widerstand (R_{P}) an das Emitterpotential angeschlossen werden kann, wird skizziert. Dargestellt sind weiterhin die Freilaufdiode (D_{F}), die Last, bestehend aus L₁ und R_{L}, und eine Streuinduktivität L₂. Die Streuinduktivität L₂ fast alle parasitären Verdrahtungsinduktivitäten zusammen.

**Fig. 7** zeigt die elektrische Wirkung der Beschaltung nach Fig. 6 am Beispiel eines 1200V-IGBT (Struktur nach Fig. 5, Stromdichte 80A/cm², Chipfläche 1cm²) im Schalterbetrieb. Wie hier ersichtlich ist, verändert sich mit einer Variation des Widerstandes (Rₚ) zwischen p- Gebiet (18) und Emitter (14) in den Grenzen von 0,01 bis 10 Ohm die Größe der drei wesentlichen Verlustanteile, die Einschaltverluste Wₒₙ , die Ausschaltverluste W_{off} und die Durchlaßspannung U_{CE}. Damit wird über das p- Gebiet und seine externe Beschaltung Einfluß auf die Verluste des Gesamtbauelements genommen.

Weiterhin kann aus Fig. 7 geschlußfolgert werden, daß durch Anschluß eines gesteuerten Widerstand an das p- Gebiet eine weitere Verbesserung der elektrischen Eigenschaften erreicht wird. So bewirkt ein bestimmter Widerstandswert beim Ausschalten eine Verringerung der Ausschaltverluste und eine gesteigerte Robustheit, ein veränderter Widerstandswert beim Einschalten minimiert die Einschaltverluste und bewirkt eine geringe Flußspannung. Die Steuerung des Widerstandes kann durch eine elektronische Schaltung erfolgen, wie sie nachfolgend in Fig. 8 dargestellt wird.

**Fig. 8** erläutert eine weitere Variante einer beispielhaften Schaltungsanordnung nach Fig. 6. Ein variabler Widerstand (Rₚ) wird hier beispielhaft durch die Parallelschaltung eines n- und p-Kanal- MOSFET (T₁, T₂) zwischen p- Gebiet und Emitter realisiert, deren Rₒₙ dem optimalen Werten für das Ein- bzw. Ausschalten entspricht und deren Gates mit dem IGBT- Gate verbunden sind.

**Fig. 9** stellt die Gesamtverluste verschiedener Trench- Gate- Strukturen in Abhängigkeit von der Schaltfrequenz dar. Es ist die Abhängigkeit der mittleren Verlustleistung von der Frequenz für die Strukturen in Fig. 2 und 4 sowie die Struktur in Fig. 5 in Abhängigkeit von der Außenbeschaltung zusammenfassend gezeigt. Bei prinzipiell gleichen statischen Durchlaßverlusten (U_{CE}) für alle 4 Varianten, sind die reduzierten Gesamtverluste Pₜₒₜₐₗ Ausdruck für die gesunkenen Schaltverluste durch die erfinderischen Maßnahmen in den Strukturen aus Fig. 4 und Fig. 5 gegenüber der Ausgangsstrukturen nach dem Stand der Technik (Fig. 2).

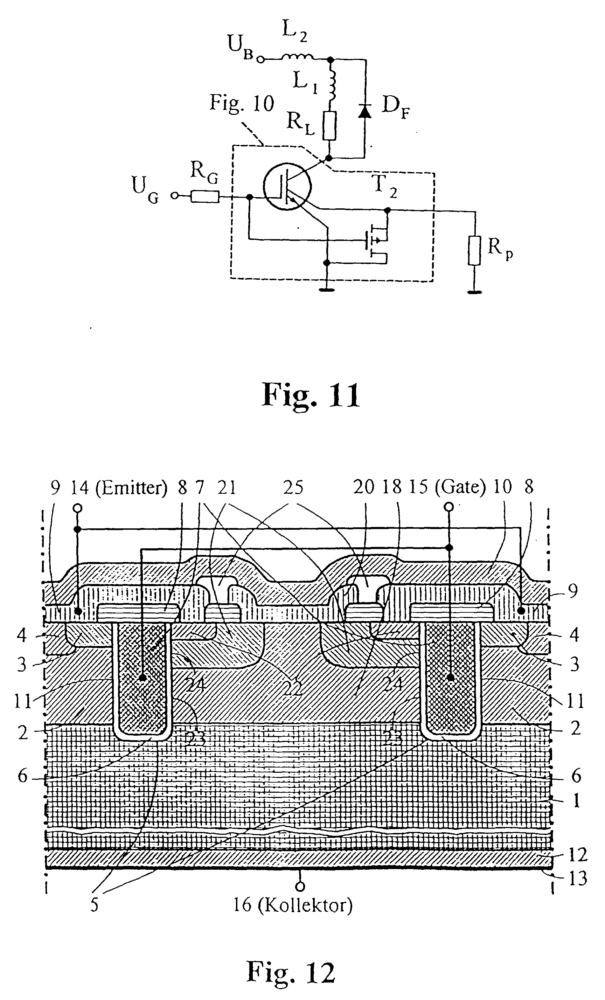

**Fig. 10** stellt ein Beispiel für die Integration von Bauelementen im p- Gebiet (18) dar. Die funktionelle Aufgabe solcher Bauelemente bzw. Schaltungen kann sowohl in der Verbesserung der elektrischen Parameter der IGBT als auch in der Ansteuerung und Überwachung bei Einsatz in Schaltungsanordnungen liegen.

Das p- Gebiet (18) kann eine geringere oder vergleichbare Eindringtiefe wie das p- Bulkgebiet (2) aufweisen. Auch kann die Eindringtiefe so gewählt werden, daß die inneren Trenchecken der Struktur umschlossen werden. Fig. 10 zeigt den zu den Fig. 1 - 5 der Hauptanmeldung analogen Ausschnitt einer IGBT- Zellstruktur, die die grundlegende Wiederholstruktur des Gesamtbauelementes darstellt. Die Trenchstrukturen (5) sind allseitig zum Silizium hin mit einem Gateisolator (6) versehen, vollständig mit Polysilizium (7) verfüllt und nach oben zum Aluminium (9) hin mit einer Passivierungsschicht (8) abgedeckt. Zwischen den streifen- oder gitterförmig angeordneten Trench- Gate- Strukturen sind im Wechsel einerseits die p-Bulkgebiete (2), die n⁺- Emittergebiete (3) und die p⁺- Bulk- Anschlußgebiete (4) sowie andererseits das p- Gebiet (18) angeordnet.

Im p- Gebiet (18) selbst ist an den Seiten der begrenzenden Trenchstruktur jeweils ein vertikaler pMOS- Transistor angeordnet, der durch die p⁺- Draingebiete (22), die n- Wanne (21, Bulk) und das p- Gebiet (18, Source) selbst gebildet wird. Gesteuert wird der pMOS-Transistor über die Gatestruktur des Trenches (5), bestehend aus dem Gateisolator (6) und dem Polysilizium- Gate (7).

Das p⁺- Draingebiet (22) des pMOS- Transistors ist über die Metallisierung (9) mit dem Emitter (14) kurzgeschlossen. P- Sourcegebiet (18) und n- Bulkgebiet (21) des pMOS-Transistors sind dagegen über die Metallisierung (20) kurzgeschlossen, die analog der in Fig. 5 als Anschluß (19) nach außen geführt wird. Dieser Anschluß kann floatend betrieben werden oder an ein äußeres Potential direkt oder über weitere Elemente angeschlossen werden. Weitere Elemente können ein fester Widerstand, ein gesteuerter Widerstand oder eine externe oder integrierte Schaltung sein.

Durch die Integration des pMOS- Transistors entsteht außerdem ein parasitärer nMOS-Transistor, bestehend aus n- Wannengebiet (21) als Source, dem p- Gebiet (18) als Bulk und dem n⁻- Substratgebiet (1) als Drain. Gesteuert wird der nMOS- Transistor über die Gatestruktur des Trenches (5).

Prinzipiell ist es auch möglich, das n- Bulkgebiet (21) nicht mit dem p- Gebiet (18) elektrisch zu verbinden und es floatend zu betreiben. Bei dieser Variante kann der parasitäre nMOS-Transistor keinen Strom führen (Source nicht angeschlossen). Nachteilig ist hierbei zu nennen, daß parasitäre Bipolar- bzw. Thyristorstrukturen gegeben wären.

**Fig. 11** zeigt eine mögliche Beschaltung der IGBT- Struktur nach Fig. 10, wobei zwischen dem Anschluß des p- Gebietes (19) und dem Emitter (14) ein fester Widerstand Rₚ geschaltet ist. Weitere übliche Elemente der äußeren Beschaltung sind die Freilaufdiode D_{F}, die Streuinduktivität L₂ und die Last, bestehend aus L₁ und R_{L}.

Der Widerstandswert für Rₚ ist dabei so zu wählen, daß sich minimale Einschaltverluste und eine geringe Flußspannung entsprechend Fig. 7 ergeben. Ein Widerstandswert in bestimmter Höhe ist auch erforderlich, damit der parasitäre nMOS- Transistor durch Source-Gegenkopplung keinen nennenswerten Strom führen kann und dadurch die elektrischen Eigenschaften der Gesamtstruktur nicht nachteilig verändert werden.

Durch die Anordnung des pMOS- Transistors als parallel geschaltete Wiederholstruktur wird eine große Kanalweite und damit ein niedriger Einschaltwiderstand für den pMOS- Transistor erreicht. Eindringtiefe und Dotierung des p- Gebietes (18) und der n- Wanne (21) sind so zu wählen und aufeinander abzustimmen, daß die Punchthrough- Reserve im p- Gebiet und damit die Sperrfähigkeit des Gesamtbauelementes gewährleistet ist und die Schwellspannung des pMOS- Transistors bei negativen Spannungen liegt (beispielhaft -3V).

Bei positiver Spannung am Polysilizium- Gate (7), z.B. +15 Volt gegenüber Emitter (14), ist der vertikale n- Kanal (11) an der einen Seite des Trenches (5) ausgebildet und der IGBT eingeschaltet während der vertikale p- Kanal (24) des pMOS- Transistors auf der anderen Seite des Trenches (5) sperrt. Bei negativer Spannung am Polysilizium- Gate (7), z.B. -15 Volt gegenüber Emitter (14), ist der vertikale n- Kanal (11) und damit der IGBT gesperrt während der vertikale p- Kanal (24) ausgebildet und der pMOS- Transistor eingeschaltet ist.

In diesem Fall kann ein Löcherstrom aus dem n⁻- Gebiet (1) des IGBT über die p-Anreicherungsschicht (23) und den p- Kanal (24) zum p⁺- Drain (22) des pMOS- Transistors fließen, der wiederum über die Metallisierung (9) mit dem Emitter (14) verbunden ist. Der Widerstand Rₚ parallel zum pMOS- Transistor trägt in diesem Fall aufgrund des höheren Widerstandswertes kaum zum Stromfluß bei.

Mit der vorgestellten Struktur in Fig. 10 und ihrer Beschaltung entsprechend Fig. 11 wird der Widerstand zwischen p- Gebiet (18) und Emitter (14) automatisch über die Trench- Gate-Spannung so gesteuert, daß während des Einschaltens des IGBT der hochohmige Widerstand Rₚ wirkt (pMOS- Transistor aus) und während des Ausschaltens des IGBT der niederohmige pMOS- Transistor leitend wird, was das Ausräumen der Löcher aus dem n⁻- Gebiet (1) beschleunigt. Damit werden die Schaltverluste vorteilhaft beeinflußt, wie das bereits zu Fig. 7 und Fig. 9 beschrieben und dargestellt wurde.

**Fig. 12** stellt eine weitere IGBT- Trench- Gate- Struktur vor, bei der auch der Widerstand Rₚ in den Halbleiterkörper integriert wird, wodurch ein zusätzlicher IGBT- Anschluß und die externe Widerstandsbeschaltung mit Rₚ entfällt. Realisiert wird dies durch ein entsprechendes hochohmiges Widerstandsgebiet (25), das beispielhaft aus Polysilizium gebildet wird und zwischen der Metallisierung (20) des p- Gebietes (18) und der Metallisierung (9) des Emitters (14) positioniert ist. Der skizzierte Ausschnitt der IGBT- Zellstruktur und die übrigen dargestellten Gebiete sind identisch zu Fig. 10.

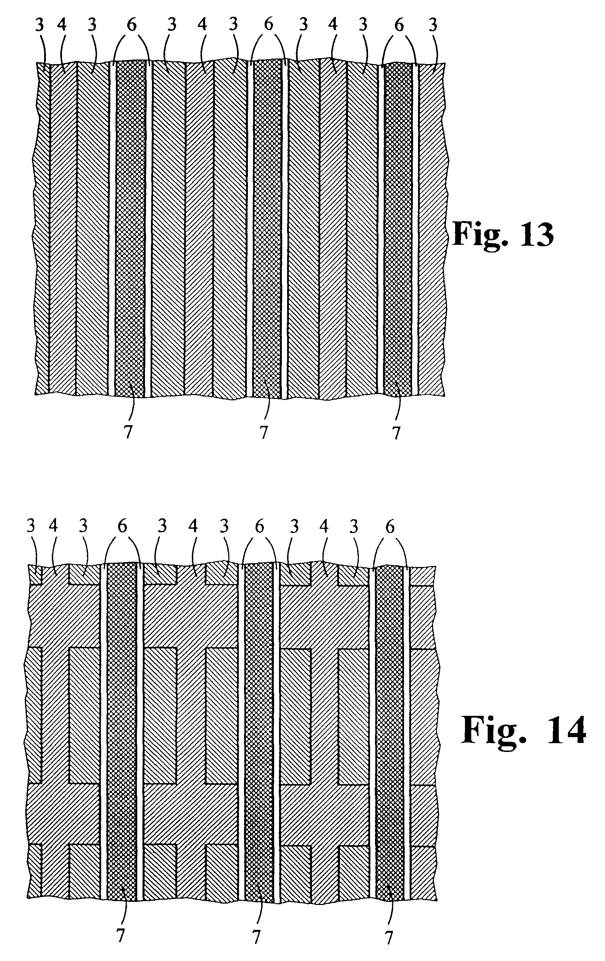

**Fig. 13** zeigt eine Draufsicht einer IGBT- Struktur mit streifenförmigem Design nach Fig. 1. Die Bezeichnung der einzelnen Elemente ist dabei beibehalten worden. Fig. 13 stellt eine reine Streifenstruktur dar. Dargestellt ist die Struktur im Silizium (ohne Deckschichten) mit streifenförmiger Polysiliziumzone (7), an der beidseitig, also an beiden Flanken die Gateoxidschicht (6) und die n⁺- Source- Gebiete (3) ausgebildet sind. Zwischen den n⁺-Source- Gebieten (3) sind die p⁺- Bulk- Anschlußgebiete (4) angeordnet.

**Fig. 14** stellt eine weitere Variante nach Fig. 13 dar. Die Streifenstruktur des Polysiliziums (7) ist in gleicher Weise ausgebildet. Die n⁺- Source- Gebiete (3) sind dagegen unterbrochen ausgebildet. Dadurch liegen einerseits n⁺- Source- Gebiete (3) und andererseits p⁺- Bulk-Anschlußgebiete (4) unmittelbar an der Oxidschicht der Gateisolation (6).

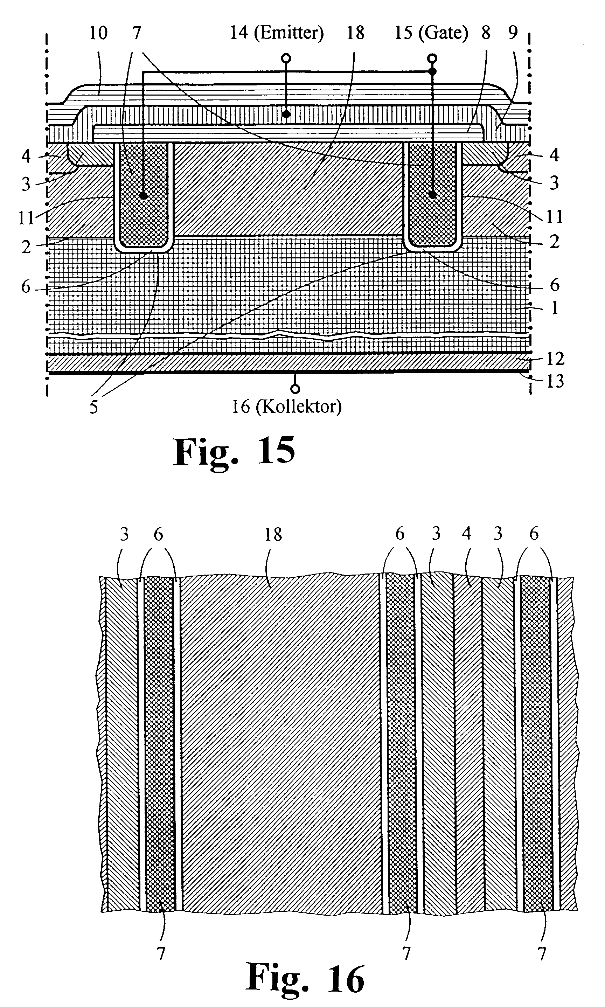

**Fig. 15** zeigt im Querschnitt die einfachste Möglichkeit einer Ausführung nach Fig. 5 mit floatendem p- Gebiet. Floatend bedeutet, daß das gesamte p- Gebiet (18) durch die Passivierungsschicht (8) abgedeckt ist. Zum Unterschied zu Fig. 5 erfolgt hier keine Anschlußmetallisierung (20) des p- Gebietes (18). Alle übrigen Zeichenelemente wurden bereits im Zusammenhang mit Fig. 5 beschrieben.

**Fig. 16** zeigt eine Draufsicht der erfinderischen Trench- Gate- Struktur in Streifenform nach Fig. 15. Der Unterschied in der Lage der Diffusionsschichten wird veranschaulicht. Das hier beispielhaft ausgeführte p- Gebiet (18) zwischen zwei Trench- Gebieten (6, 7) einerseits alterniert mit den bereits beschriebenen n⁺- Source- Gebieten (3) und p⁺- Bulk-Anschlußgebieten (4) andererseits in strikter Einhaltung dieser Regel.

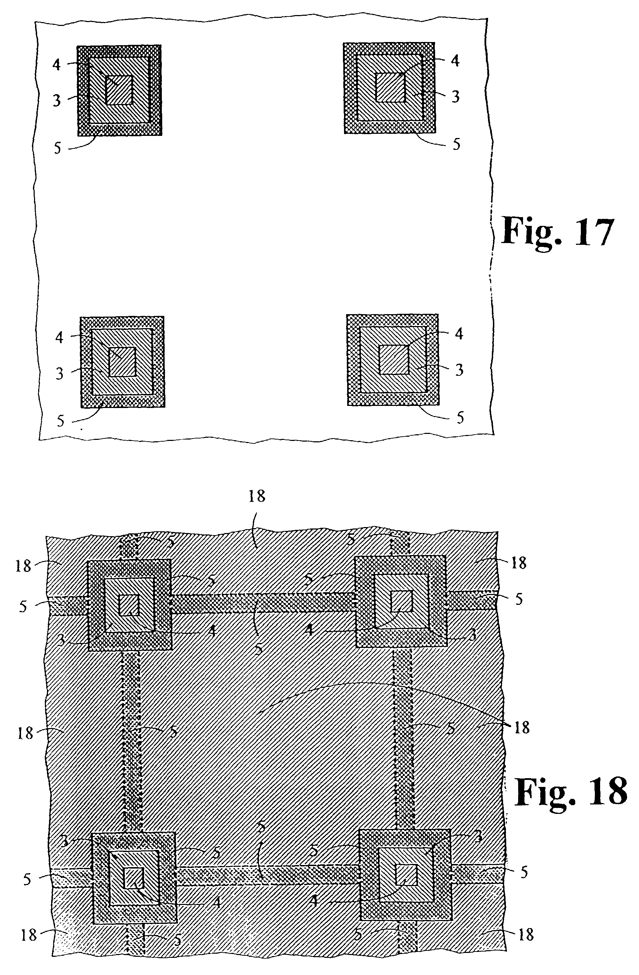

**Fig. 17** stellt die Inselstruktur der Trench- Gate- Zellen dar. Die erfinderischen einzelnen Trench- Gate- Zellen sind voneinander räumlich und elektrisch getrennt. Gezeichnet ist ein Design- Ausschnitt mit vier einzelnen Zellen. Sie bestehen dem Prinzip nach aus dem p⁺- Bulk-Anschlußgebiet (4), n⁺- Source- Gebiet (3) und dem Trench (5). Die einzelnen Trenches sind voneinander isoliert. Die Zwischenräume zwischen den Trench- Gate- Zellen sind alternativ Isolatorgebiete (17), Dotierungsgebiete (18) des zweiten Leitungstyps oder Substratgebiete (1) des ersten Leitungstyps.

**Fig. 18** zeigt eine mögliche erfinderische Variante der elektrischen Verbindung nach Fig. 17. Die Verbindung mit Trench- Gebieten (5 - gestrichelt) mittels vergrabener Gebiete ist technologisch in dem gleichen Verfahrensschritt bei der Herstellung der Trenches möglich.

Die vorgestellte Umsetzung der erfinderischen Idee bezuglich der Schaffung von elektrischen Verbindungen der einzelnen Trenches untereinander ist technologisch optimal in der Herstellung und relativ kostengünstig.

Die erfinderische Lösung bietet in dem Halbleitervolumen den Platz für die beispielhaft ausgeführte Trenchstruktur. In den Trench- Gräben (5 - gestrichelt) lassen sich technologisch Polysilizium- Leitbahnen zur elektrischen Kontaktierung der Trenches untereinander einbringen. Das Gateoxid (6) im Trench (5) und die Passivierung (8) isolieren die vergrabenen Leitbahnen vollständig. Bei sonst beliebigen Zellstrukturen (z.B. Quadrate, Rechtecke oder Sechsecke) können die erfinderischen elektrischen Verbindungen ausgeführt werden.

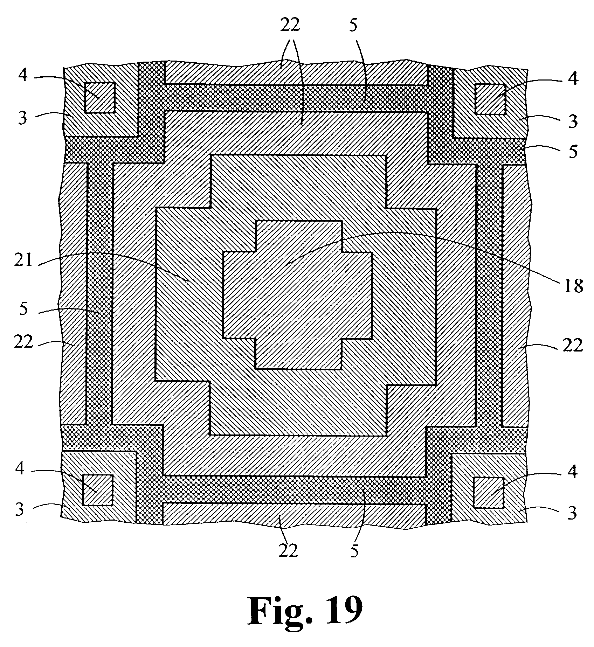

**Fig. 19** zeigt die Draufsicht der Trench- Gate- Struktur nach Fig. 12 bei zellförmigem Design. Die Möglichkeit sehr komplexe Anordnungen zu realisieren wird dargestellt. Diese Struktur beinhaltet in seinem p- Gebiet (18 - Source) die n- Wanne (21, Bulk), in dieser wiederum das p+- Draingebiet (22). Die weiteren Zeichnungselemente wurden bereits vorgestellt.

Alternativ lassen sich die Verbindungen zwischen den räumlich und elektrisch getrennten Trench- Gate- Strukturen auch über Metall- oder Polysilizium- Leitbahnen auf der Siliziumoberfläche realisieren. Dazu sind jedoch einerseits zusätzliche Leitbahnen und Isolationsschichten oder andererseits strukturierte Anschlußgebiete, wie sie beispielhaft durch Fingerstrukturen in der Metallisierung gebildet werden können, erforderlich.

Vorteilhafte Ausgestaltungen für eine erfinderische Schaltung ergeben sich aus den nachfolgend genannten Dimensionierungen, die beispielhaft offengelegt werden. Die Trenchstrukturen (5) sollten eine Trenchtiefe von 1µm bis 15µm sowie eine Trenchbreite zwischen 1µm und 4µm besitzen, wobei der Abstand der Trenchstrukturen auf der einen Seite, der Seite mit der vertikalen MOS- Struktur, also dem MOS- Transistor- Anschlußgebiet (3) und (4), vom verwendeten Lithographieniveau zur Realisierung des Emitteranschlusses (14) abhängt.

Der Abstand der Trenchstrukturen wird auf der anderen Seite, der Seite mit dem sich anschießenden Isolator-(17), Dotierungs-(18) oder Substratgebiet (1), durch die vorgegebene Sperrspannungsklasse des TIGBT und dessen Trenchgeometrie bestimmt.

Für einen 1200V- TIGBT mit einem p- Bulkgebiet (2) von 3µm bis 5µm sollte die Trenchtiefe 4µm bis 6µm und die Trenchbreite 1µm bis 2µm betragen, wobei der Abstand der Trenchstrukturen auf der einen Seite, der Seite mit der vertikalen MOS- Struktur, also dem MOS- Transistor- Anschlußgebiet (3) und (4) zwischen 4µm und 10µm breit ist und der Abstand der Trenchstrukturen auf der anderen Seite, der Seite mit dem sich anschießenden Isolator-(17), Dotierungs-(18) oder Substratgebiet (1) zwischen 15µm und 25µm beträgt.

## Patentansprüche

1. Leistungshalbleiterbauelement als Trench- Gate- IGBT (Insulated Gate Bipolar Transistor) mit einer n-fachen Anzahl aneinandergrenzender gleichartiger Zellen, mit einem Substratgebiet des ersten Leitungstyps (1), mit einem Rückseitenemitter vom zweiten Leitungstyp (12), mit einer vertikalen MOS- Struktur, mit streifen-, insel- oder gitterförmig angeordnete Trenchstrukturen (5), die allseitig zum Silizium hin mit einem Gateisolator (6) versehen, mit Polysilizium (7) verfüllt und mit einer Passivierungsschicht (8) abgedeckt sind,
**dadurch gekennzeichnet, daß**
jede Zelle zwei schmale Trenchstrukturen (5) enthält, an deren zum Zelläußeren gewandten vertikalen Flanken sich je eine vertikale MOS- Struktur, bestehend aus Bulkgebieten (2) des zweiten Leitungstyps, dessen mit der Emitterelektrode verbundenen Anschlußgebiete (4) vom zweiten Leitungstyp, sowie einem innerhalb des Bulkgebietes (2) liegenden ebenfalls mit der Emitterelektrode verbundenen Source- bzw. Emittergebiet (3) vom ersten Leitungstyp und zwischen deren zum Zellinneren gewandten vertikalen Flanken sich ein Dotierungsgebiet (18) vom zweiten Leitungstyp, ein Isolatorgebiet (17) oder ein Substratgebiet des ersten Leitungstyps (1) befindet.

2. Trench- Gate- IGBT nach Anspruch 1, dadurch gekennzeichnet, daß
in jeder Zelle in dem Dotierungsgebiet (18) des zweiten Leitungstyps Wannengebiete (21) vom ersten Leitungstyp sowie Dotierungsgebiete (22) vom zweiten Leitungstyp und/oder Dotierungsgebiete (3) vom ersten Leitungstyp ausgebildet sind.

3. Trench- Gate- IGBT nach Anspruch 2, dadurch gekennzeichnet, daß
die Wannengebiete (21) und Dotierungsgebiete (22) zusammen mit dem p- Gebiet (18) und dem Substratgebiet (1) Transistoren, wie pMOS, nMOS, Bipolartransistoren und/oder integrierte Schaltungen bilden, die durch Metallisierungsgebiete (9, 20) kontaktiert sind.

4. Trench- Gate- IGBT nach Anspruch 3, dadurch gekennzeichnet, daß
zwischen der Metallisierung (9) des Emitters (14) und einer Metallisierung (20) der integrierten Bauelemente des p- Gebietes eine Wiederstandsschicht eingebracht ist.

5. Trench- Gate- IGBT nach Anspruch 1, dadurch gekennzeichnet, **daß**
das zwischen den Trenchstrukturen liegende p- Gebiet (18) floatend ist oder mit einer Elektrode (20) kontaktiert ist und mit einer äußeren Beschaltung versehen wird.

6. Trench- Gate- IGBT nach Anspruch 1, dadurch gekennzeichnet, **daß**
das Isolatorgebiet (17) aus Siliziumdioxid und/oder Siliziumnitrid besteht.

7. Trench- Gate- IGBT nach Anspruch 1, dadurch gekennzeichnet, **daß**
die Trenchstrukturen (5) eine Trenchtiefe von 1µm bis 15µm sowie eine Trenchbreite zwischen 1µm und 4µm besitzen, und der Abstand der Trenchstrukturen auf der einen Seite, der Seite mit der vertikalen MOS- Struktur, also dem MOS- Transistor- Anschlußgebiet (3) und (4), vom verwendeten Lithographieniveau zur Realisierung des Emitteranschlusses (14) abhängt und der Abstand der Trenchstrukturen aufder anderen Seite, der Seite mit dem sich anschießenden Isolator-(17), Dotierungs-(18) oder Substratgebiet (1), durch die vorgegebene Sperrspannungsklasse des Trench- IGBT und dessen Trenchgeometrie bestimmt wird.

8. Trench- Gate- IGBT nach Anspruch 1, dadurch gekennzeichnet, **daß**
für einen 1200V- Trench- IGBT mit einem p- Bulkgebiet (2) von 2µm bis 5µm die Trenchtiefe 4µm bis 6µm sowie die Trenchbreite 1µm bis 2µm beträgt, der Abstand der Trenchstrukturen auf der einen Seite, der Seite mit der vertikalen MOS- Struktur, also dem MOS- Transistor- Anschlußgebiet (3) und (4) zwischen 4µm und 10µm breit ist und der Abstand der Trenchstrukturen auf der anderen Seite, der Seite mit dem sich anschießenden Isolator-(17), Dotierungs-(18) oder Substratgebiet (1) zwischen 15µm und 25µm beträgt.

9. Trench- Gate- IGBT nach Anspruch 1, dadurch gekennzeichnet, daß
räumlich und elektrisch isolierte Trench- Gate- Zellen ausgebildet wurden, die zusätzliche Trench- Gate- Strukturen oder Metall- oder Polysilizium- Leitbahnen zur elektrischen Verbindung aufweisen.
